(19) **Europäisches Patentamt European Patent Office Office européen des brevets**

(11) **EP 2 442 908 B1**

(12) **EUROPEAN PATENT SPECIFICATION**

(45) Date of publication and mention of the grant of the patent:
**18.03.2015 Bulletin 2015/12**

(51) Int Cl.:
*B01L 3/00* (2006.01)          *B05D 7/22* (2006.01)
*C23C 16/04* (2006.01)          *C23C 16/505* (2006.01)

(21) Application number: **10724520.1**

(22) Date of filing: **18.06.2010**

(86) International application number:
**PCT/EP2010/058631**

(87) International publication number:
**WO 2010/146153 (23.12.2010 Gazette 2010/51)**

(54) **METHOD OF SURFACE TREATING MICROFLUIDIC DEVICES**

VERFAHREN ZUR OBERFLÄCHENBEHANDLUNG VON MIKROFLUIDISCHEN VORRICHTUNGEN

PROCÉDÉ DE TRAITEMENT DE SURFACE POUR DISPOSITIFS MICROFLUIDIQUES

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **19.06.2009 GB 0910626**

(43) Date of publication of application:
**25.04.2012 Bulletin 2012/17**

(73) Proprietor: **Dublin City University Dublin D9 (IE)**

(72) Inventors:
  • **GANDHIRAMAN, Ram Prasad**
    **Tamilnadu 641001 (IN)**
  • **BASABE-DESMONTS, Lourdes**
    **Cartagena (ES)**
  • **RIAZ, Asif**
    **Rawalpindi (PK)**
  • **LEE, Luke**
    **Orinda**
    **California 94563 (US)**
  • **DIMOV, Ivan**
    **Puerto Montt (CL)**
  • **DUCREE, Jens**
    **Meath**
    **Meath (IE)**
  • **DANIELS, Stephen Michael**
    **Dublin 9 (IE)**

(74) Representative: **Moore, Barry et al**
    **Hanna Moore & Curley**
    **13 Lower Lad Lane**
    **Dublin 2 (IE)**

(56) References cited:
    **WO-A1-2006/083600      WO-A2-2009/060194**

    • **MARTIN I T ET AL: "Plasma modification of PDMS microfluidic devices for control of electroosmotic flow" PLASMA PROCESSES AND POLYMERS WILEY-VCH GERMANY, vol. 4, no. 4, 23 May 2007 (2007-05-23), pages 414-424, XP002601930 ISSN: 1612-8850**
    • **JANSEN F ET AL: "THIN FILM DEPOSITION ON INSIDE SURFACE BY PLASMA ENHANCED CHEMICAL VAPOR DEPOSITION" THIN SOLID FILMS, ELSEVIER-SEQUOIA S.A. LAUSANNE, CH LNKD- DOI:10.1016/0040-6090(94)90821-4, vol. 252, no. 1, 15 November 1994 (1994-11-15), pages 32-37, XP000474735 ISSN: 0040-6090**

**Description**

**Field of the Invention**

The present invention relates to methods of surface treating microfluidic devices and more particularly to surface treating of channels or cavities within a fabricated microfluidic device by provision of a layer thereon. Depending on the nature of the materials forming the layer such a layer may provide a barrier layer preventing subsequent material ingress to the substrate material of the microfluidic device, or may just selectively modify the properties of that portion of the channel or cavity on which the layer is provided.

**Background**

Microfluidic devices are well known in the art and typically comprise a plurality of individual cavities or fluid channels defined within a substrate and through which a fluid may be stored or flow. The dimensions of the individual cavities or channels are typically of the order of a human hair. Usually the length of such channels is much greater than their width. Such kinds of channels, their geometrical variations and their networks are used in the microfluidic devices for various purposes such as DNA sequencing, separation by electrophoresis, cell sorting and culturing, biomolecular analysis, biological and chemical synthesis. Within the art, the development of microfluidic devices not only introduced possible miniaturization of the existing analytical technologies but also new opportunities to conduct novel experiments in non conventional formats for mining information otherwise difficult to obtain.

Among the materials for the fabrication of microfluidic devices, polydimethylsiloxane (PDMS) has been a most popular material, offering a range of advantages such as, rapid prototyping, inertness, biocompatibility, optical transparency, and permeability, etc.. Despite these advantages, the surface chemistry of the microfluidic channels in PDMS remains a major issue since organic solvents or small molecules can penetrate through PDMS substrate. Furthermore, it provides a hydrophobic surface which promotes nonspecific adsorption or even absorption of small molecules into the bulk mass of the PDMS substrate. This non-desired adsorption can affect the ultimate analysis for which the microfluidic device is being used. It will be appreciated that PDMS is an example of a silicon based organic polymer

A further disadvantage arising from the use of PDMS substrates is related to the absence of functional groups on the PDMS surface which reduces the possibility of covalently immobilizing bio-molecules or other custom designed functionalities. Such functionalities are available using other substrates such as for example glass.

Despite these apparent limitations, PDMS remains a preferred choice for use in fabricating microfluidic devices and attempts have been made to address the issues associated with the nature of the substrate material. Examples of known attempts which are used to resolve the hydrophobic issue is to expose the channels defined within the PDMS substrate to ozone or oxygen plasma for a short time which renders the surface hydrophilic usually for less than an hour. While this addresses the issues of hydrophobicity, it is very much time delimited and requires processing concurrently with the testing that is to be conducted. Other approaches which do not require such concurrent processing include various wet chemical strategies such as graft polymerization, silanization and, adsorption of detergents, proteins, polyelectrolytes, and sol-gel based coating. While these approaches allow for a surface treatment of the channel or cavity surfaces in advance of use of the microfluidic devices, these techniques are tedious, require skilful handling, Moreover, multiplexing of such methods on large scale may perhaps induce complications in process parameters which involve flushing/storing reagents or chemicals that are not environmentally friendly.

Martin IT et al "Plasma modification of PDMS microfluidic devices for control of electroosmotic flow" PLASMA PROCESSES AND POLYMERS WILEY-VCH-GERMANY vol 4 no 4 23 May 2007 pages 414-424 describes how polydimethylsiloxane (PDMS} capillary electrophoresis microchips were modified using plasma-enhanced chemical vapor deposition (PECVD), resulting in modified electroosmotic flow (EOF) values. They demonstrate how PECVD can be used to treat preassembled polymer microfluidic devices.

WO2009060194 provides an apparatus for plasma treating a surface of a small (channel 12) to modify the surface and change the functional effect. The apparatus comprises: a source of active species for supply to an inlet of a processing region for forming a plasma in the processing region; means for applying an electric field to the active species in the processing region so that a plasma is formed; and vacuum pumping means for connection to an outlet of the processing region. The vacuum pumping means are operable to provide a flow path in the processing region from the inlet to the outlet thereof and to control pressure in the processing region. The apparatus further comprises supporting means for supporting at least one small channel so that, in use, the flow path extends therethrough, and an internal surface of said at least one small channel is coated with a thin film polymer layer by plasma deposition.

There is therefore a continued need for devices and methodologies for fabricating such devices which overcomes these and other problems.

## Summary

These and other problems are addressed by surface treating surfaces of fluidic channels or cavities of a previously fabricated microfluidic device having a plurality of fluidic channels defined therein by providing the microfluidic device within a gas plasma reactor and using the gas plasma reactor to generate a metal oxide or metalloid oxide layer surface layer on individual surfaces of the plurality of fluidic channels, the surface layer resultant from a gas diffusion process. Judicious selection of a precursor compound used within the gas plasma reactor can provide for generation of a layer on the individual surfaces. If the properties of the layer are such as to provide a barrier layer that barrier layer will operably minimise the ingress of materials through the layer from the fluidic channels and into the bulk substrate of the microfluidic device. The invention also provides a method of fabricating a microfluidic device comprising providing one or more channels or cavities within a substrate and effecting through a plasma generated gas deposition process the generation of a metal oxide or metalloid oxide surface or barrier layer on individual ones of the channels or cavities. Desirably the surface or barrier layer is generated through the chemical adsorption of a metalloid oxide such as a silicon oxide layer on the surface of the individual channels or cavities.

The invention therefore provides a method according to claim 1 with advantageous embodiments being detailed in the dependent claims. These and other features of the invention will now be described with reference to exemplary embodiments of the invention.

## Brief Description Of The Drawings

Figure 1A is a schematic showing formation of SiOx barrier in PDMS microcavities in accordance with an exemplary arrangement.

Figure 1B is a schematic process flow showing how a barrier layer may be generated in accordance with the present teaching.

Figure 1C is a schematic showing an exemplary arrangement for generating a barrier layer in accordance with the present teaching.

Figure 2(a) is a schematic diagram of acquiring energy dispersive x-ray spectrum and Figure 2(b) is an EDX spectrum of a barrier layer formed on zeonor (left) and that of native zeonor (right).

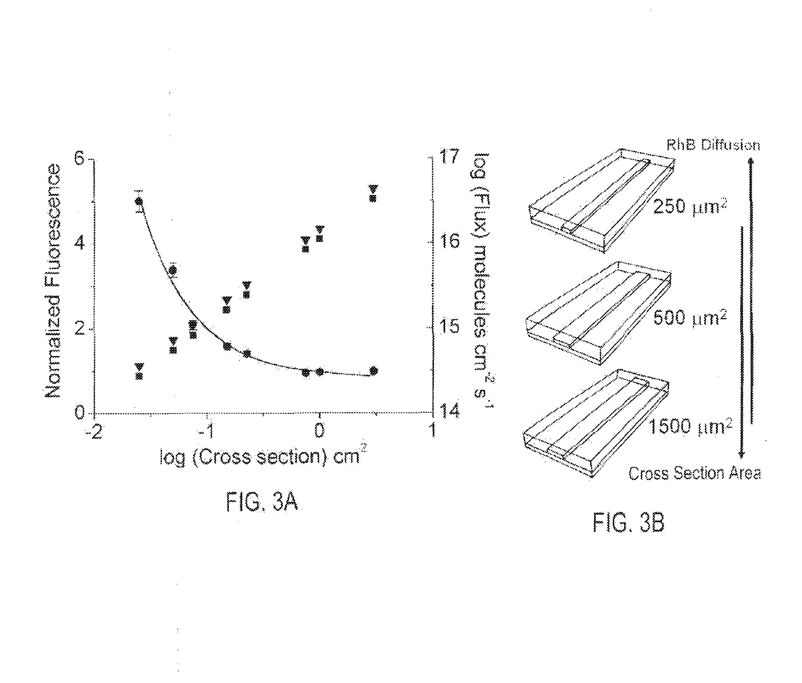

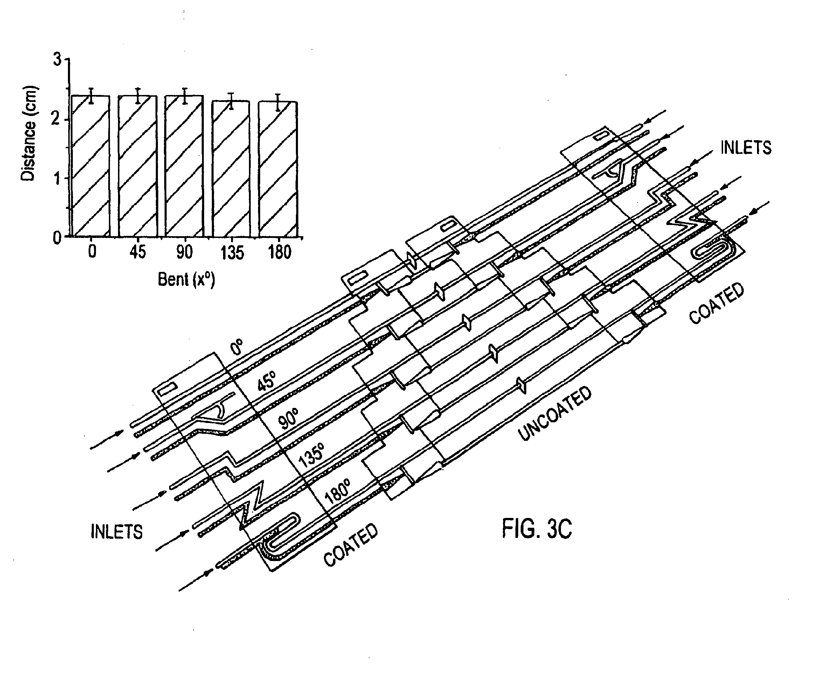

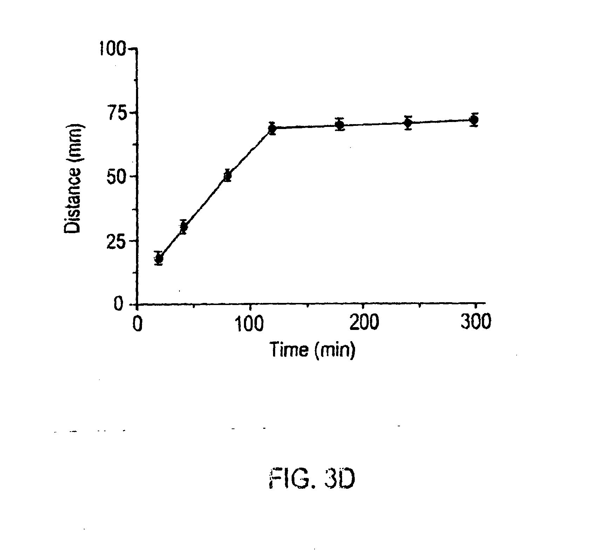

Figure 3 shows the effect of cross sectional area of the cavity on barrier formation with: Figure 3(a) showing the efficiency of blocking RhB penetration with respect to cross sectional area of a cavity inlet; Figure 3(b) showing RhB penetration into PDMS using fluorescent images of RhB penetration into PDMS at successive cross sectional areas of the cavities; Figure 3(c) showing the effect of bends provided in the cavity on barrier formation; and Figure 3(d) showing results representing the reproducibility, high throughput and maximum penetration depth achievable using techniques in accordance with the present teaching.

Figs. 4a and 4b shows experimental results evidencing the thickness of the barrier along the cavity length with respect to time of the reaction and pressure in the chamber in accordance with an exemplary arrangement of the present teaching.

Figure 5 shows in Figure 5(a) absorption data of small molecules and the results of refreshing the surface after use, in Figure 5(b) the improvements in resistance to deformation with toluene by incorporation of a barrier layer in accordance with the present teaching, and in Figure 5(c) stability results representative of electro-osmotic flow and reproducible electrophoresis.

## Detailed Description of the Drawings

The teaching of the present invention will now be described with reference to an exemplary arrangement whereby a silicon oxide barrier layer is provided on individual surfaces of channels or cavities defined within a PDMS based substrate microfluidic device. Using this exemplary arrangement a method of formation of a barrier layer composed of silicon oxides in microcavities of assembled polymeric microfluidic devices for use in biological assays or chemical analyses known as biochips or lab-on-a-chip devices will be described. Furthermore, methodologies providing for the surface modification of covered microfluidic channels in polydimethylsiloxane (PDMS) substrate using a dry chemical process of plasma enhanced chemical vapour deposition (PECVD) will be described. The surface modified PDMS showed presence of silicon oxide ($SiO_x$) moieties on surface responsible for inducing surface functionalization to $Si-O^-$ (silanol groups) and hydrophilic character to the channels. The presence of Si and O in the barrier was characterised by using energy dispersion x-ray spectroscopy. It will be understood and appreciated by the person skilled in the art that these exemplary arrangements are provided to assist in an understanding of the teaching of the present invention and it is not intended to limit the teaching to such exemplary arrangements as modifications can be made without departing from the scope of the present teaching.

In accordance with this exemplary arrangement, it is possible to fabricate and form a glass like highly efficient barrier on PDMS microcavities. It will be appreciated that the microfluidic device may be provided in a monolithic structure or may be fabricated from two or more layers that are bonded to one another. These layers may be fabricated from the same or different materials. In contrast to wet chemical treatments employed by prior art arrangements, the methodology employed in accordance with the present teaching is based on gas phase reaction.

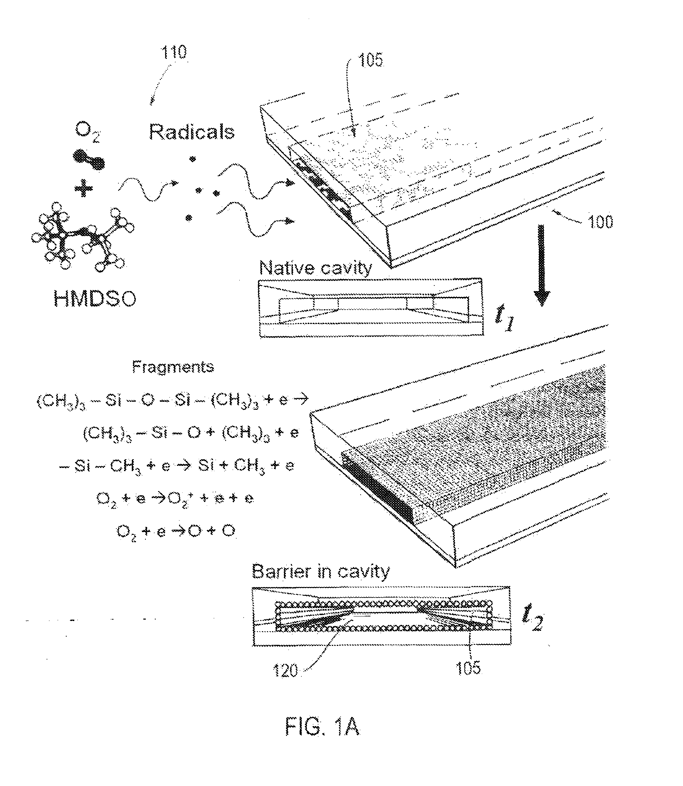

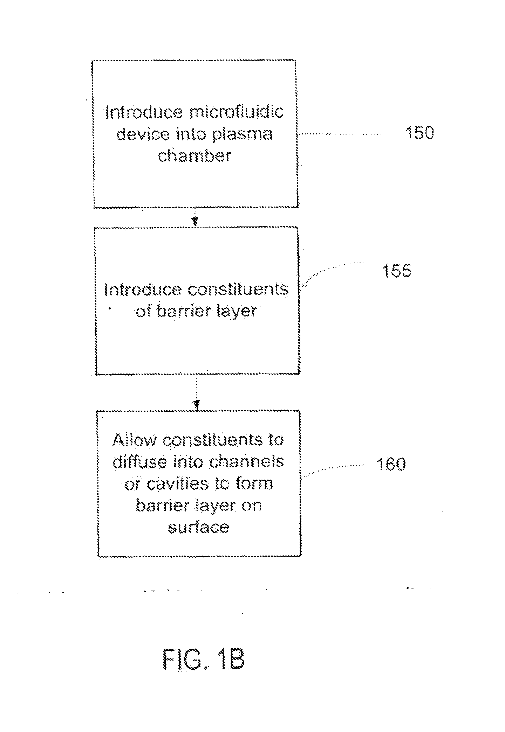

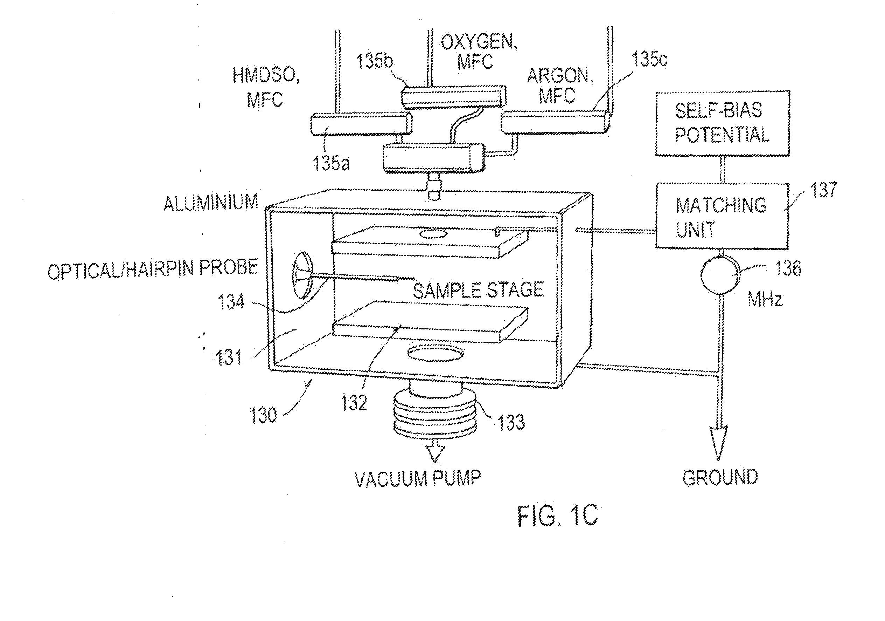

Figure 1 shows a schematic illustration of the process. A microfluidic device 100, which is ready for the formation of glass like thin film barrier within one or more channels 105 defined within the device 100, is provided in a gas plasma reactor or chamber occupied with a plasma environment (Step 150). An example of such a plasma system 130 is shown In Figure 1C. The system provides a reactor or reaction chamber 131, fabricated for example from aluminium, and having a sample stage 132 provided therein within which the assembled microfluidic device may be placed. The pressure within the chamber 131 may be controlled or modified using a vacuum pump 133 in fluid communication with the chamber. The nature of the generated plasma may be monitored using for example an optical or hairpin probe 134. Using this analysis, it is then possible to vary the plasma conditions so as to optimise the process. Gas feeds 135, in this example providing hexamethyldisiloxane (HMDSO) 135a, oxygen 135b and argon 135c are provided to allow a controlled introduction of those gases into the interior volume of the chamber. A power source 136 is provided via a matchbox 137 so as to allow for a varying of the potential within the plasma chamber. It will be understood that by varying the potential and/or pressure within the chamber that the plasma conditions may be varied.

It will be appreciated by those of skill in the art that plasmas with complex chemistry are composed of a multitude of atomic and molecular species. Within the context of the present teaching the make-up of the plasma is determined by a capacity of specific atomic and molecular species to react with the surfaces of channels or cavities within a microfluidic device to form a thin film or etch the surface. These 'radicals' are usually formed by dissociation of the feedstock gases introduced into the plasma chamber 131. The relative densities of these radicals depend on the power coupled into the plasma, the precise gas mixture, and the chamber geometry.

Within the context of the present teaching, it is understood that the species which form the film in non-line-of-sight or high aspect ratio regions of the device, reach their reaction site by diffusion. This diffusion process if governed by several parameters, including the energy and cross sections of the species, surface sticking coefficients, and pressure.

The densities of the species that result in the formation of the film determine the deposition rate and the relative densities of the depositing species determine the film stoichiometry. The presence of other species can often result in a net removal rather than a deposition rate due to the presence of energetic species which cause sputtering or chemical etch.

Using this understanding the present inventors have provided for an optimisation of the plasma process to ensure the desired chemical composition of the plasma is achieved. There are several sensor techniques for monitoring and controlling the relative density of species in a plasma such as optical emission spectroscopy (OES), mass spectroscopy, laser absorption spectroscopy, etc. In the case of optical emission spectroscopy, species emit light at characteristic wavelengths which indicate the presence of these species. The intensity of the emitted peak is often an indicator of the density of the species, albeit it is not a representation of the actual absolute density of the species. This can be achieved by more advanced analysis such as actinometry.

By controlling parameters such as the density of the depositing species (and the chemical etch species), through a combination of process set-points and process sensors, it is possible within the context of the present teaching to optimize the densities of the radical species available for diffusion into the channels.

It will be understood that the potential applied within the gas plasma reactor may be selected dependent on the source available and the intended process parameter requiring control; for example it may be an RF source but microwave or other potential sources may also be used. When precursors in the form of $O_2$ gas and HMDSO vapours are introduced (Step 155) into the chamber, the fragments (radicals, ions or elemental species) 110 of these molecules are produced, and as will be appreciated by those skilled in the art, as a result of the bombardment of energetic electrons and ions in the plasma. It is believed that since the charged species oscillate with the RF power in the plasma, that the radicals of Si and O are more likely to migrate into the microcavities by diffusion These radicals but nonetheless reactive fragments diffuse into the cavities defined within the previously assembled or fabricated microfluidic device through their open inlets, survive, and react on the surfaces within the channels 105 to form a thin glassy barrier 120 (Step 160). It will be appreciated that the formation of the "glassy" barrier is representative of the properties of the silicon oxide layer that is formed. The layer formed is through a gas phase diffusion process, and the radicals being adsorbed onto the surface to form chemical bonds at favorable sites to raise an amorphous network. It has been found that providing oxygen to HMDSO ratios greater than 10, more homogeneous $SiO_x$ radicals are produced and the film property approaches to that of silica-like. In one exemplary arrangement, the flow rates of $O_2$ and HMDSO, were selected to be 500 sccm and 16 sccm respectively.

Characterisation of the barrier layer was done using energy dispersion x-ray spectroscopy (EDX). Since the cavities are in strong dielectric medium, the probability of charged particles migrating into the cavities is low. While it is not intended to limit the application of the present teaching to any one specific methodology or understanding it is believed that the radicals or elemental species are more likely to migrate into the cavities and subsequently react on the walls to form the barrier. In the plasma, besides other fragments the presence of Si radicals and elemental O could be verified, using optical emission spectroscopy, from their specific emissions near 519 nm, 777 nm and 884 nm respectively.

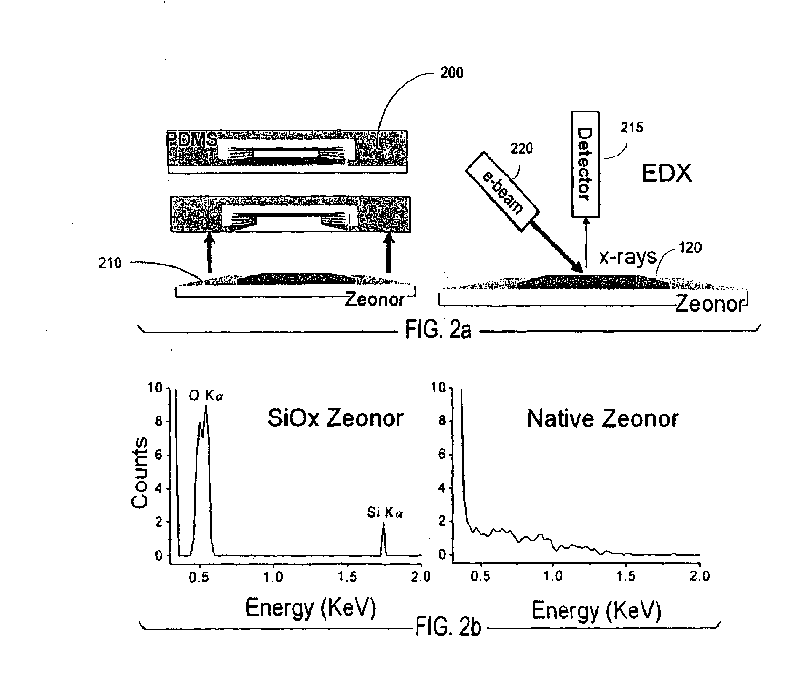

Since PDMS contains Si as one of its constituents, to confirm that the observed Si characteristic of the EDX spectrum was resultant from a generated barrier layer as opposed to a silicon constituent of the PDMS a further experiment was conducted whereby a barrier layer was formed on channels within a microfluidic device fabricated from a plastic (Zeonor) substrate. Figure 2 shows results from this secondary analysis whereby the presence of Si and O in the barrier was observable and confirmed by observing, using a detector 215, the response of the barrier to an incident e-beam provided from an X ray source 220. The EDX spectrum of Figure 2 clearly indicates energy signals from O-$K\alpha$ and Si-$K\alpha$ near 0.5 keV and 1.78 keV, respectively. However, EDX signal were not detected from O and Si on bare Zeonor. The existence of Si and O on surface treated Zeonor channels suggests that radicals or elemental like reactants of Si and O migrated through the cavities by diffusion and then deposited on the walls giving rise a barrier as composed of oxides of silicon ($SiO_x$). It will be appreciated that the generated silicon oxide layer is representative of a non-stoichiometric compound layer, in that the composition cannot be represented by a ratio of well-defined numbers of silicon to oxygen. While the presence of trace elements of contaminants or other materials within the final layer cannot be discounted, the dominant feature of the layer is the presence of silicon and oxide- which due to their combination together effects the generation of a glass like barrier layer on the surfaces of the individual channels. This glassy like barrier layer exhibits hydrophilic properties and will typically have a contact angle less than 90°, typically less than 60°.

It will be understood that the analysis of the EDX spectrum both supports the generation of the $SiO_x$ barrier layer on the PDMS substrate of Figure 1 but also that the teaching of the present invention should not be limited to such specific PDMS type substrates in that using gas diffusion mechanisms it is possible to surface treat individual channels of a microfluidic device formed in other substrate materials.

The quality of the barrier was examined by introducing a dye which exhibits affinity for PDMS into a microfluidic device fabricated from a PDMS substrate. Rhodamine B (RhB) is such a dye and Figure 3 shows (a) the efficiency of blocking RhB penetration with respect to cross sectional area of the cavity inlet. The dots are the measurements of the RhB fluorescence intensity (n =3)., after 1 hr of storing the RhB solution in the cavities. The solid line shows exponential fitting of the points with the equation (y = yo + A1e(-X /t1)) with R2 = 0.990, yo = 0.8190 ($\pm$ 0.146), A1 = 702.5 ($\pm$ 445.3), and t1 = 0.469 ($\pm$ 0.0586). Calculated flux of molecular mass available for diffusion with respect to cross section area of the cavity (triangles O, squares Si). (b) RhB penetration into PDMS. Fluorescent images of RhB penetration into PDMS at successive cross sectional areas of the cavities were analysed. By comparing any changes in the fluorescent images as the dye is stored for extended durations in the microcavity, it is possible to evaluate the efficacy of the barrier layer in preventing transmission through the layer and into the base substrate below. The RhB solution was stored in both a bare PDMS microfluidic device (i.e. one whose surfaces were not treated using the methodologies of the present invention) and one with a glass like thin film barrier such as may be fabricated using the present teaching. The images were recorded at various times. Given the affinity of RhB to PDMS, RhB molecules penetrated into the bare PDMS microcavity as expected and a gradual increase in the width of the fluorescent region with time could be observed. This region kept on growing in size and luminosity with the passage of time. However, in channels with a barrier layer, the penetration of RhB molecules was efficiently blocked by the glass like barrier. For fixed conditions of the barrier formation reaction, the efficiency of the barrier against blocking RhB into PDMS showed a strong dependence on the cross section area of the cavity inlet. As shown in Fig. 3a the barrier showed drastic improvements in blocking RhB as the cross section of the cavity was increased, where the solid line is an exponential fit with $R^2$ value of 0.990. This can be attributed to the fact that the net flux '$J_{net}$' of the particles diffusing into the cavity increases with increasing the cross section '$A$' as:

$$ J_{net} = -DA\frac{dn}{dx} \qquad\qquad (1) $$

where, '$D$' is the diffusion coefficient, '$dn/dx$' the density of particles along the cavity length. The flux of particles ($\phi$)

impinging an area could be estimated by using the relation $\left( \phi = 3.513 \times 10^{22} PA / \sqrt{MT} \right.$ , where P is the pressure in torr, $M$ the molecular weight, and $T$ the temperature). Estimated flux of O and Si impinging the respective cross sectional area is plotted in Fig. 3a, which suggests that larger number of reactive species could be available for diffusion into cavities with the larger inlet areas. In this way higher pressure within the chamber and higher applied power may be considered as contributing to the diffusion distances achieved by the gas radicals into the microfluidic device.

It will be appreciated that the present invention relies upon a gas diffusion of constituent materials of the ultimate surface layer into the individual channels of the microfluidic devices and then their ultimate chemical binding with one another and adsorption onto the surfaces of the channels to define a layer on those surfaces.

Individual ones of the constituents may deposit initially on the surfaces and then provide a reaction site for combination with the other constituents. In this way it will be appreciated that it is not intended to limit the present invention to a methodology that requires reaction and then adsorption. It will be appreciated however that by introducing elemental materials in a gas phase into defined channels, that the ultimate formation of the barrier layer will be affected by surface interactions by those elemental materials with the surfaces of the channels or cavities. In this way it would be expected that channels having a plurality of bends would provide more reaction surfaces than substantially straight channels. To evaluate the effect of such bends and the depth at which a barrier layer may be generated within a microfluidic device, generation of a $SiO_x$ barrier was studied in a device comprising bends within the individual channels. For this experiment we used long cavities of 5,000 $\mu m^2$ inlets cross section. Here we have to consider that pressure in the plasma chamber was maintained near 300 mTorr. At such a pressure mean free paths ($\lambda_{mfp}$) for Si and O were estimated as 1.42 x 10$^{-4}$ m and 2.72 x 10$^{-4}$ m, respectively, $\left( \lambda_{mfp} = RT / \sqrt{2} \pi d^2 N_A P \right.$ , where $T$ is the temperature, d the atomic diameter, $N_A$ the Avogadro's number, and $P$ the pressure). In steady equilibrium state we expect no pressure difference between the reaction chamber and in the cavity. Gas flow in the cavity may not be applicable here because the cavity has either one dead end or both ends open in the plasma. These experimental conditions suggest that mass transfer in the cavity is possible through a diffusion phenomenon. If this is true a bend in the cavity should not affect the barrier formation deeper in the cavity past an initial bend. To evaluate this long channels were fabricated with a duplex of intentional bends of 45°, 90°, 135°, 180° as shown in Figure 3c. The barrier was grown in the cavities and the efficiency of the barrier was studies using RhB penetration. The coated distances of the barrier along the length of the cavities were measured from the inlets of the cavities to the distance which was blocked for RhB penetration into PDMS as depicted with arrows overlapping with the "coated" region in Figure 3c. The distance of the barriers was plotted against the bends (bar graph, Fig. 3c), which did not show significant variations depending on the bend they crossed, indicating that the growth of the barrier was independent of the bends in the channels. Therefore, we could assume that the migration of the reactants in cavities is based on molecular diffusion.

Reproducibility of the barrier formation was studied in a multiplex of very long meandering cavities of 40 individual units (Figure 3.d). The multiplex platform was subjected to the barrier formation and efficiency of the barrier was studied. The coated distances with the barrier in the cavities are indicated by arrows which show excellent reproducibility of the process. In another experiment the coated distances of the barrier was studied with time of the reaction in the similar multiplex platforms. We observed that the coated distance increased with the time of reaction and then reached a limiting distance after certain time as plotted in Figure 3.d. This could be attributed to the depletion of the reactants as one of the possible factors. Since the possibility of fragmentation reactions in the cavities is low, a plausible mechanism might exist in a way that formation of the reactive species takes place in the plasma chamber, and the fragments diffuse into the cavities. During the course of migration by diffusion the reactants deposit on the surface of the cavity and while others keep on surviving the collusions for later deposition. Experimental measurements reveal that in these test conditions (Figure 3d) the barrier grows deep into the cavity at the rate of ca. 10 $\mu m/s$. The maximum coated distance observed was about 70,000 $\mu m$ in 2 hrs in the cavities. In order to verify the source of the limiting reactant an experiment was conducted in the absence of HMDSO precursor and the formation of barrier was studied. In the absence of HMDSO, the barrier formation was not efficient and RhB penetration was more or less similar to that in the bare PDMS cavities. This observation suggests that the organo-silico precursor, in this instance HMDSO, is a necessary precursor for an efficient barrier formation and perhaps Si radicals derived from this HMDSO are the limiting reactants.

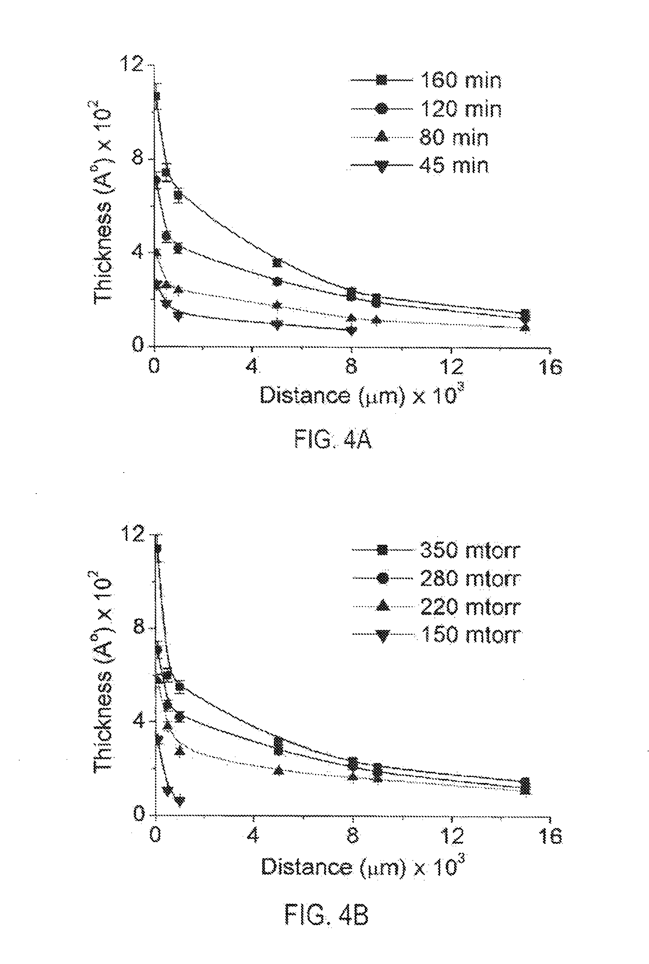

Thickness of the barrier was determined with respect to time of the reaction and pressure in the chamber maintaining the ratio of $O_2$ and HMDSO. A slab of PDMS bearing grooves was bonded to Si wafer so that the microcavities have a bottom of Si wafer. The barrier was formed and the device was disassembled. The Si wafer was used for determining the thickness of the barrier using a surface profilometer. As shown in Figure 4, the thickness of the barrier increases with increasing the time of reaction and pressure in the chamber. From this analysis it is evident that the dimensions of the layer may be fabricated to be of the order of nanometres such that the layer forms a thin layer on the individual surfaces of the channels or cavities. In this way it will be understood that using a methodology in accordance with the present teaching that the formed layer does not alter significantly the geometry of the channels or cavities.

The thickness curves in Fig. 4 show similar trends as calculated for an arbitrary reaction in the cavities under operating pressure in the chamber. Roughness of the $SiO_x$ barrier was estimated by atomic force microscopy, which was similar to that found in native PDMS

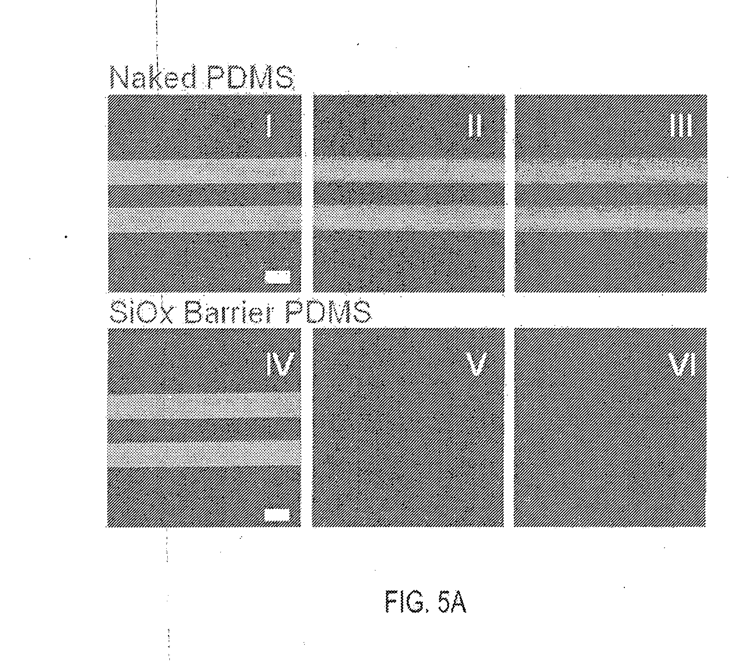

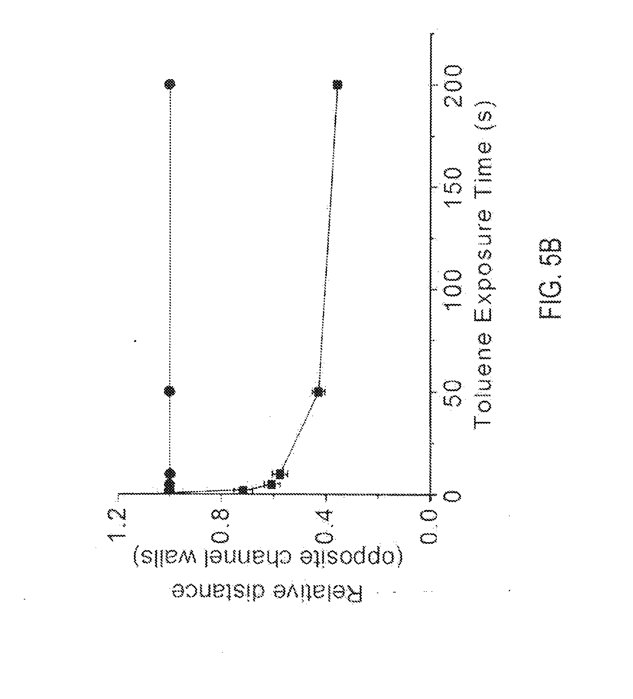

The barrier in PDMS channels was tested for various applications such as absorption of small biomolecules, resistance to organic solvents, and electrophoresis. It is known that PDMS exhibits an affinity for certain small molecules which absorb in PDMS surface. Once absorbed, the surface may be considered contaminated with such molecules and it is difficult to wash them away. Tetramethyl rhodamine isothiocyanate (TRITC) is a derivative of rhodamine and is frequently used for biomolecular labeling. TRITC labelled biotin solution was stored in bare and $SiO_x$ barrier PDMS channels and after 1 hour the channels were washed with 0.1 M NaOH and then with 1.0 M NaOH solutions. The state of the channels could be compared by fluorescent images after each washing as shown in Figure 5a. The freshness of the channel surfaces returned after first washing in $SiO_x$ barriered channels, however, in the case of bare channels a residual fluorescence of biotin-TRITC was visible even after second drastic washing with concentrated NaOH (1 M). It's a well known fact that if bare PDMS is exposed to organic solvents, it starts swelling due to absorption of the solvent molecules. Particularly, toluene severely changes the topology of PDMS surfaces. Toluene was stored in bare and $SiO_x$ barrier treated PDMS channels and time series images were recorded and compared in Figure 5b. It was found that the barrier protected the PDMS and showed excellent resistance to toluene - as evidenced by the relatively constant line linking dots, while naked or bare channels started swelling immediately upon exposure to toluene showing progressive narrowing of the channel by collapsing of the walls and roof of the channel, as shown by the line fitted to the squares.

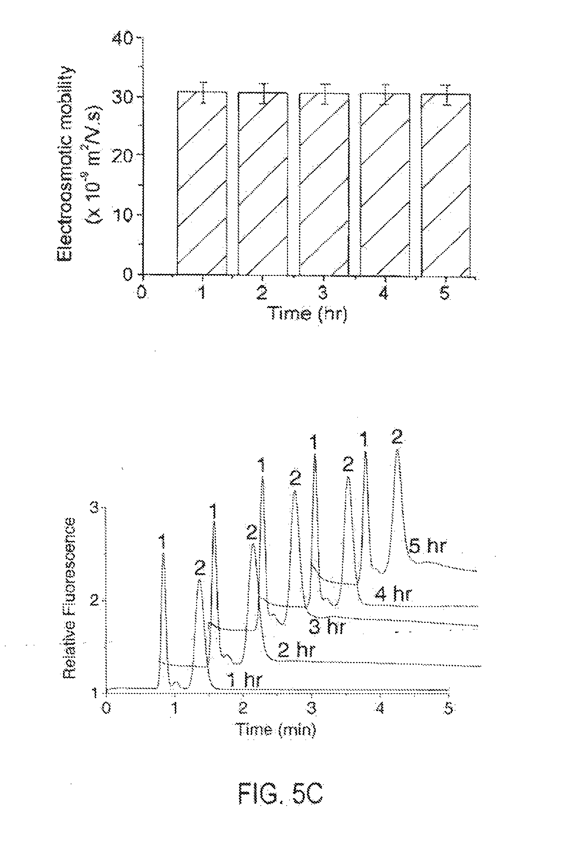

For reproducible electrophoresis experiments in narrow channels a stable charge on the surface (zeta potential) is required for stable electro-osmotic flow (EOF), however, bare PDMS shows an unstable EOF due to its uncontrollable characteristic of nonspecific absorption property. Electrophoresis experiments in a $SiO_x$ barrier channel using a pH 9.0 buffer solution showed a stable EOF (Figure 5c-I). The magnitude of EOF in our $SiO_x$ barrier channel was comparable to that determined in conventional fused silica capillaries. The magnitude of EOF strongly supports the existence of a stable zeta potential on the barrier and could be due to silanol (Si-O⁻) ions since EDX suggests the presence of Si and O in the barrier. A mixture of two analytes fluorescein and dichlorofluorescein was separated in $SiO_x$ barrier channel (anode at injection end), usually known as normal polarity mode. In such conditions the magnitude of EOF (~31 x $10^{-9}$ $m^2$/V.s) could be compared to that found in conventional fused silica capillaries. In fact, the EOF was strong enough to pull the negatively charged small molecules against their electrophoretic mobility as shown in Figure 5c-II. The separation achieved in those channels incorporating a barrier layer provided good reproducibility in migration times (relative standard deviation 3%, *n* = 5). It will be noted that electropherograms in Figure 5c were acquired at different times without inter-run washings. However, in the case of bare channels reproducibility in migration times declines drastically, usually in 30 minutes of the first electrophoresis separation.

It will be appreciated that the generation of microfluidic devices with a barrier layer formed on the surfaces of individual channels or cavities has been described with reference to an exemplary arrangement whereby the device is fabricated in a PDMS substrate and the barrier layer is generated through gas diffusion of elemental Si resultant from HMDSO precursors and oxygen introduced into a plasma environment. Such barrier layers have been described as the result of diffusion of gas phase highly reactive chemical species into long microcavities leading to a surface reaction within the polymeric cavities. The reactive species created from fragmentation of $O_2$ and hexamethyldisiloxane (HMDSO) in an RF plasma environment diffused into microcavities of polydimethylsiloxane (PDMS) to form an efficient glass like thin film barrier. The reactive species like silicon radicals and elemental oxygen maintained their reactivity for sufficiently longer time and survived random walks in the cavities. The barrier was observed at significantly deep distances along the length of the cavities. The barrier thickness and the growth length could be controlled by the reaction time, and the operating pressure in the chamber. It has been described how increasing the cross section area of the cavity inlet and/or decreasing the mean free path, such as by increasing the pressure, increases the thickness of the barrier. The barrier showed a strong resistance to organic solvent like toluene and prevented the PDMS microfluidics from swelling and deformation.

Moreover, the formation of glass like thin film on PDMS microfluidic channels solved the stability problem of electro-osmotic flow (EOF) in naked PDMS microfluidic devices. Reproducible separations by electrophoresis, which was comparable to that in conventional fused silica capillaries were also demonstrated. In this way the present teaching provides a dry physicochemical method of creating $SiO_x$ barrier in polymeric microfluidic channels which is reproducible, robust, and up scaling on industrial scale may be more straightforward than for the conventional wet chemical methods. A wide range of applications of such techniques are possible in various fields for example for coating the covered surfaces of microfluidic channels, tubes, capillaries, medical devices, catheters, and advanced electronic and opt-fluidic packaging.

Therefore while such exemplary arrangements have been described to assist the person skilled in the art in an understanding of the benefit and teaching of the present invention, such exemplary arrangements are not provided to limit the teaching to such exemplary arrangements, Modifications can be made to that described herein without departing from the spirit and or scope of the present teaching. For example the channels or cavities could be fabricated in other materials such as plastics, metals, polymers, and elastomeric materials. Furthermore in the context of a generation of a Si based barrier layer, HMDSO represents a suitable precursor material other organo silicon precursors such as any of hexamethyldisiloxane, tetramethylsilane, tetraethoxysilane, hexamethylcyclotrisiloxane, octamethylcyclotetrasiloxane, and tetramethylcyclotetrasiloxane or similar compounds could be utilised.

While the generation of a glassy barrier layer is predicated on the use of silicon (silicon being a constituent of glass), other barrier layer could also be fabricated by varying the choice of elemental materials introduced into the individual channels or cavities. Indeed silicon is exemplary of a metalloid material that can be used to generate a metalloid oxide layer within the microfluidic device and the use of other metalloid materials will result in the ultimate fabrication of other metalloid oxide layers. Furthermore using such gas plasma reactions it is possible to generate metallic oxide layers within the microfluidic devices. The generated silicon oxide layer is typically provided as an amorphous film on the surface of the individual channels and by replacing the organo-silica precursor with a metallic precursor such as titanium tetraisopropoxide $Ti(OC_3H_7)_4$ it is possible to generate amorphous metallic layers of titanium oxide on the surfaces of the individual channels. Titanium oxide coatings have particular application in biomedical applications. By combining the HMDSO precursor with a Ti precursor in the presence of oxygen it is possible to further improve the wettability of the final layer provided on the surface of the individual microchannels beyond that achievable using pure silicon precursors.

While the geometries of individual channels have been described in little detail it will be appreciated that the surface layer could be formed onto individual features within the micro-channels such as micro pillars, trenches, and wells etc., and it is not intended that the application of the methodologies of the present invention be construed as being limited only to surface treatment of fluidic passages. By providing surface treatment of individual sites within the channels or cavities it is possible to provide target reaction sites within the microfluidic devices at specific locations. In the context of vaporizable organo precursors and $O_2$ in highly energetic plasma environment the subsequent barrier is resultant from a deposit on the substrate surfaces forming the thin film barrier SiOx coating giving rise to ionisable silanol (Si-O⁻) groups so that the thin film barrier of SiOx can be a substitute of glass like surface.

It will be appreciated that heretofore the surface treatment of the channels or cavities within the microfluidic device has been described with regard to a single process effected within a gas plasma reactor that subsequent to the formation of the surface layer other surface treatments could be effected to further modify the response characteristics of the microfluidic device. For example, if a channel is coated with a SiOx layer through methodologies such as that described heretofore, that the coated layer of SiOx bearing silanol groups can be further functionalized. Examples of the type of functional groups that could be generated include amine, polyethylene glycol, proteins or DNA that could be generated using techniques such as wet chemical or gas phase reactions.

It will be appreciated that where the surface treatment of cavities or channels within a device has been described herein that it is not intended to limit that surface treatment to individual channels or cavities and it is intended to include networks of such channels or cavities within the general nomenclature of channels or cavities. Within this context it will be appreciated that by use of a diffusion process that it is possible to coat meander patterns defined by the channels or cavities within the microchannel. The use of a diffusion process does not require direct concurrent exposure of the target surfaces as the radicals will enter the channels at one end and migrate along the path defined by the channel, coating along the way. Using such a process allows the surface treating of channels or cavities having aspect ratios (the ratio of the length of the channel to its width) greater than 10. Indeed using a process in accordance with the teaching of the present invention it has been possible to surface treat microchannels having lengths of the order of cm, representing aspect ratios >>10. By using an optimised diffusion process to surface treat the channels, it is possible to coat the channels despite the channels and their side walls or surfaces being wholly defined within the microstructure. In this way it will be appreciated that a process in accordance with the present teaching may be used to treat channels or cavities having surfaces extending fully about their perimeter, those channels or cavities being fully defined within the interior volume of the microfluidic device, Channels or cavities within the context of the present teaching having individual surfaces that extend fully about the channel or cavity are in this way not open channels, where the length of the channel is accessible from an exterior of the microfluidic device.

Therefore although the invention has been described with reference to exemplary illustrative embodiments it will be appreciated that specific components or configurations described with reference to one figure may equally be used where appropriate with the configuration of another figure. Any description of these examples of the implementation of the invention are not intended to limit the invention in any way as modifications or alterations can and may be made without departing from the scope of the invention. It will be understood that the invention is not to be limited in any way except as may be deemed necessary in the light of the appended claims.

Similarly, the words comprises/comprising when used in this specification are to specify the presence of stated features, integers, steps or components but does not preclude the presence or addition of one or more other features, integers, steps, components or groups thereof.

**Claims**

1. A method of surface treating individual surfaces of channels or cavities within a fabricated microfluidic device, the channels or cavities having surfaces extending fully about their perimeter, the method comprising:

   a) Providing the fabricated microfluidic device having the one or more channels or cavities defined therein within a gas plasma reactor;
   b) Using the plasma reactor to effect the generation of radical species comprising elemental metal or metalloid radicals, the radical species representing constituents of a surface treatment layer
   c) Allowing generated radical species to diffuse in a gaseous form into the one or more channels or cavities; and

   wherein on introduction of the radical species into the channels or cavities, the radical species react with one another to form a metal oxide or metalloid oxide layer on the surfaces of the one or more channels or cavities and further wherein direct plasma deposition does not directly contribute to the generation of the surface layers.

2. The method of claim 1 wherein the layer is generated through deposition of the constituents onto surfaces of the channels or cavities.

3. The method of claim 1 or 2 wherein the constituents are selected so as to effect generation of a silicon oxide layer on surfaces of the individual ones of the respective channels of cavities.

4. The method of any preceding claim wherein the constituents are introduced in an RF plasma environment.

5. The method of any preceding claim wherein the layer is generated through gas phase deposition of the constituents onto the surfaces of the one or more channels or cavities.

6. The method of any preceding claim wherein the constituents comprise oxygen or organo-silicon compounds or radicals derived therefrom.

7. The method of any preceding claim wherein the constituents are generated through a vaporization of an organo-silicon precursor and oxygen within the gas plasma reactor.

8. The method of claim 7 wherein the organo-silicon precursor is selected from one of: hexamethyldisiloxane, tetramethylsilane, tetraethoxysilane, hexamethylcyclotrisiloxane, octamethylcyclotetrasiloxane, and tetramethylcyclotetrasiloxane.

9. The method of claim 7 wherein the precursors are provided with a ratio of oxygen to organo-silico compounds greater than 10.

10. The method of Claim 9 wherein the organo-silico compounds are hexamethyldisiloxane (HDMSO), and optionally wherein the oxygen and HDMSO are provided into the plasma chamber with flow rates of 500 sccm and 16 sccm respectively.

11. The method of any preceding claim wherein the microfluidic device is fabricated from two or more substrates and wherein the channels or cavities are defined between the two or more substrates and further wherein the two or more substrates meet along a common plane, the channels or cavities extending substantially parallel to that plane.

12. The method of any preceding claim wherein the channels or cavities have an aspect ratio greater than 10, and, or, wherein the channels or cavities define a meander pattern within the device.

13. The method of any preceding claim wherein the plasma is tuneable to modify the availability of the radicals for subsequent diffusion into the channels or cavities, and, or, wherein the pressure within the chamber is sufficient to allow diffusion of the radicals into the cavities or channels, desirably wherein the pressure within the chamber is about 300mTorr.

14. The method of any preceding claim comprising providing titanium into the gas plasma reactor to effect generation of a titanium oxide layer on individual surfaces of the microfluidic device.

**15.** The method of any preceding claim including, on generating a layer on individual channels or cavities, of functionalising that layer, wherein the functionalising the layer includes generation of functional groups selected from one of: amine, polyethylene glycol, proteins or DNA

**Patentansprüche**

**1.** Verfahren zur Oberflächenbehandlung einzelner Oberflächen von Kanälen oder Hohlräumen innerhalb einer produzierten mikrofluidischen Vorrichtung, wobei die Kanäle oder Hohlräume Oberflächen aufweisen, die sich vollständig um deren Umfang erstrecken, wobei das Verfahren umfasst:

a) Bereitstellen der produzierten mikrofluidischen Vorrichtung mit dem einen oder den mehreren, darin gebildeten Kanälen oder Hohlräumen innerhalb eines Gasplasmareaktors;
b) Verwenden des Plasmareaktors, um die Erzeugung von Radikalspezies zu bewirken, die elementare metallische oder metalloide Radikale umfassen, wobei die Radikalspezies Bestandteile einer Oberflächenbehandlungsschicht darstellen,
c) Zulassen, dass erzeugte Radikalspezies in gasförmiger Form in den einen oder die mehreren Kanäle oder Hohlräume diffundieren; und

wobei bei Einleitung der Radikalspezies in die Kanäle oder Hohlräume die Radikalspezies miteinander reagieren, um ein Metalloxid oder eine metalloide Oxidschicht auf den Oberflächen des einen oder der mehreren Kanäle oder Hohlräume zu bilden, und wobei darüber hinaus eine direkte Plasmaabscheidung nicht direkt zur Erzeugung der Oberflächenschichten beiträgt.

**2.** Verfahren nach Anspruch 1, wobei die Schicht durch Abscheidung der Bestandteile auf Oberflächen der Kanäle oder Hohlräume erzeugt wird.

**3.** Verfahren nach Anspruch 1 oder 2, wobei die Bestandteile so gewählt sind, dass eine Erzeugung einer Siliziumoxidschicht auf Oberflächen einzelner jeweiliger Kanäle oder Hohlräume bewirkt wird.

**4.** Verfahren nach einem vorhergehenden Anspruch, wobei die Bestandteile in eine HF-Plasmaumgebung eingeleitet werden.

**5.** Verfahren nach einem vorhergehenden Anspruch, wobei die Schicht durch Gasphasenabscheidung der Bestandteile auf den Oberflächen des einen oder der mehreren Kanäle oder Hohlräume erzeugt wird.

**6.** Verfahren nach einem vorhergehenden Anspruch, wobei die Bestandteile Sauerstoff oder Organo-Silizium-Verbindungen oder davon abgeleitete Radikale umfassen.

**7.** Verfahren nach einem vorhergehenden Anspruch, wobei die Bestandteile durch Verdampfung eines Organo-Silizium-Vorläuferstoffs und Sauerstoff im Gasplasmareaktor erzeugt werden.

**8.** Verfahren nach Anspruch 7, wobei der Organo-Silizium-Vorläuferstoff ausgewählt ist aus: Hexamethyldisiloxan, Tetramethylsilan, Tetraethoxysilan, Hexamethylcyclotrisiloxan, Octamethylcyclotetrasiloxan und Tetramethylcyclotetrasiloxan.

**9.** Verfahren nach Anspruch 7, wobei die Vorläuferstoffe mit einem Verhältnis von Sauerstoff zu Organo-Silizium-Verbindungen von über 10 bereitgestellt werden.

**10.** Verfahren nach Anspruch 9, wobei es sich bei den Organo-Silizium-Verbindungen um Hexamethyldisiloxan (HDMSO) handelt, und optional wobei Sauerstoff und HDMSO in der Plasmakammer mit Durchflussraten von 500 cm$^3$/min bzw. 16 cm$^3$/min bereitgestellt werden.

**11.** Verfahren nach einem vorhergehenden Anspruch, wobei die mikrofluidische Vorrichtung aus zwei oder mehr Substraten produziert wird und wobei die Kanäle oder Hohlräume zwischen den zwei oder mehr Substraten gebildet sind und darüber hinaus wobei die zwei oder mehr Substrate sich entlang einer gemeinsamen Ebene treffen und die Kanäle oder Hohlräume weitgehend parallel zu dieser Ebene verlaufen.

**12.** Verfahren nach einem vorhergehenden Anspruch, wobei die Kanäle oder Hohlräume ein Seitenverhältnis von über 10 aufweisen und, oder wobei die Kanäle oder Hohlräume eine Mäanderstruktur innerhalb der Vorrichtung bilden.

**13.** Verfahren nach einem vorhergehenden Anspruch, wobei das Plasma abstimmbar ist, um die Verfügbarkeit der Radikale für eine anschließende Diffusion in die Kanäle oder Hohlräume zu modifizieren und, oder wobei der Druck in der Kammer ausreichend groß ist, um eine Diffusion der Radikale in die Hohlräume oder Kanäle zu ermöglichen, wobei der Druck in der Kammer wünschenswerterweise ca. 300 mTorr beträgt.

**14.** Verfahren nach einem vorhergehenden Anspruch, umfassend, Titan in den Gasplasmareaktor einzubringen, um die Erzeugung einer Titanoxidschicht auf einzelnen Oberflächen der mikrofluidischen Vorrichtung zu bewirken.

**15.** Verfahren nach einem vorhergehenden Anspruch, umfassend, bei der Erzeugung einer Schicht auf einzelnen Kanälen oder Hohlräumen, diese Schicht zu funktionalisieren, wobei die Funktionalisierung der Schicht die Erzeugung von funktionalen Gruppen umfasst, die ausgewählt sind aus: Amin, Polyethylenglykol, Proteine oder DNA.

## Revendications

**1.** Procédé de traitement de surface de surfaces individuelles de canaux ou de cavités à l'intérieur d'un dispositif microfluidique fabriqué, les canaux ou cavités ayant des surfaces s'étendant complètement autour de leur périmètre, le procédé comprenant :

a) la fourniture du dispositif microfluidique fabriqué comportant le(s) canal/canaux ou la(les) cavité(s) défini(e)s à l'intérieur d'un réacteur à plasma ;
b) l'utilisation du réacteur à plasma pour induire la génération d'espèces radicalaires comprenant des radicaux métalliques ou métalloïdes élémentaires, les espèces radicalaires représentant des constituants d'une couche de traitement de surface ;
c) la possibilité de diffusion des espèces radicalaires générées sous forme gazeuse dans le(s) canal/canaux ou la/les cavité(s) ; et

dans lequel lors de l'introduction des espèces radicalaires dans les canaux ou cavités, les espèces radicalaires réagissent les unes avec les autres pour former une couche d'oxyde métallique ou d'oxyde métalloïde sur les surfaces du canal/des canaux ou de la/des cavité(s) et dans lequel, en outre, le dépôt direct de plasma n'intervient pas directement dans la génération des couches de surface.

**2.** Procédé selon la revendication 1, dans lequel la couche est générée par le dépôt des constituants sur les surfaces des canaux ou des cavités.

**3.** Procédé selon la revendication 1 ou 2, dans lequel les constituants sont choisis pour assurer la génération d'une couche d'oxyde de silicium sur les surfaces des canaux ou des cavités respectifs/respectives individuel(le)s.

**4.** Procédé selon l'une quelconque des revendications précédentes, dans lequel les constituants sont introduits dans un environnement plasma RF.

**5.** Procédé selon l'une quelconque des revendications précédentes, dans lequel la couche est générée par dépôt en phase gazeuse des constituants sur les surfaces du canal/des canaux ou de la/des cavité(s).

**6.** Procédé selon l'une quelconque des revendications précédentes, dans lequel les constituants comprennent des composés d'oxygène ou d'organo-silicium ou des radicaux dérivés de ceux-ci.

**7.** Procédé selon l'une quelconque des revendications précédentes, dans lequel les constituants sont générés par vaporisation d'un précurseur d'organo-silicium et d'oxygène à l'intérieur du réacteur à plasma.

**8.** Procédé selon la revendication 7, dans lequel le précurseur d'organo-silicium est choisi parmi : hexaméthyldisiloxane, tétraméthylsilane, tétraéthoxysilane, hexaméthylcyclotrisiloxane, octaméthylcyclotétrasiloxane et tétraméthylcyclotétrasiloxane.

**9.** Procédé selon la revendication 7, dans lequel les précurseurs sont dotés d'un rapport oxygène sur composés d'organo-silicium supérieur à 10.

**10.** Procédé selon la revendication 9, dans lequel les composés d'organo-silicium sont l'hexaméthyldisiloxane (HDMSO), et éventuellement dans lequel l'oxygène et le HDMSO sont fournis dans la chambre à plasma à des débits de 500 sccm et 16 sccm, respectivement.

**11.** Procédé selon l'une quelconque des revendications précédentes, dans lequel le dispositif microfluidique est fabriqué à partir de deux substrats ou plus et dans lequel les canaux ou cavités sont définis entre les deux substrats ou plus et dans lequel en outre les deux substrats ou plus se rencontrent sur un plan commun, les canaux ou cavités s'étendant sensiblement parallèlement à ce plan.

**12.** Procédé selon l'une quelconque des revendications précédentes, dans lequel les canaux ou cavités ont un rapport hauteur/largeur supérieur à 10, et/ou dans lequel les canaux ou cavités définissent un motif en serpentin à l'intérieur du dispositif.

**13.** Procédé selon l'une quelconque des revendications précédentes, dans lequel le plasma est ajustable pour modifier la disponibilité des radicaux pour une diffusion subséquente dans les canaux ou cavités, et/ou, dans lequel la pression à l'intérieur de la chambre est suffisante pour permettre la diffusion des radicaux dans les cavités ou canaux, de manière souhaitable dans lequel la pression à l'intérieur de la chambre est d'environ 300 mTorr.

**14.** Procédé selon l'une quelconque des revendications précédentes comprenant la fourniture de titane dans le réacteur à plasma pour induire la génération d'une couche d'oxyde de titane sur les surfaces individuelles du dispositif microfluidique.

**15.** Procédé selon l'une quelconque des revendications précédentes incluant, lors de la génération d'une couche sur des canaux ou cavités individuels/individuelles, la fonctionnalisation de cette couche, dans lequel la fonctionnalisation de la couche inclut la génération de groupes fonctionnels choisis parmi l'un des groupes suivants : amine, polyéthylène glycol, protéines ou ADN.

FIG. 1A

```
┌─────────────────────────┐
│   Introduce microfluidic │
│   device into plasma     │ ············ 150
│   chamber                │
└─────────────────────────┘
            │
            ▼
┌─────────────────────────┐
│   Introduce constituents │ ⎯⎯⎯ 155
│   of barrier layer       │
│                          │
└─────────────────────────┘
            │
            ▼
┌─────────────────────────┐
│   Allow constituents to  │
│   diffuse into channels  │ ········ 160
│   or cavities to form    │
│   barrier layer on       │
│   surface                │
└─────────────────────────┘
```

FIG. 1B

FIG. 1C

EP 2 442 908 B1

FIG. 2a

FIG. 2b

FIG. 3B

FIG. 3A

FIG. 3C

FIG. 3D

FIG. 4A

FIG. 4B

Naked PDMS

I     II     III

SiOx Barrier PDMS

IV     V     VI

FIG. 5A

FIG. 5B

FIG. 5C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2009060194 A

**Non-patent literature cited in the description**

• Plasma modification of PDMS microfluidic devices for control of electroosmotic flow. **MARTIN IT et al.** PLASMA PROCESSES AND POLYMERS. WILEY-VCH, 23 May 2007, vol. 4, 414-424